Europäisches Patentamt

European Patent Office

Office européen des brevets

(19)

(11) Veröffentlichungsnummer : **0 548 129 B1**

(12) # EUROPÄISCHE PATENTSCHRIFT

(45) Veröffentlichungstag der Patentschrift :
15.06.94 Patentblatt 94/24

(51) Int. Cl.⁵ : **G01R 27/16,** G01R 27/08,
H02H 3/38

(21) Anmeldenummer : 91915747.9

(22) Anmeldetag : 28.08.91

(86) Internationale Anmeldenummer :
PCT/DE91/00692

(87) Internationale Veröffentlichungsnummer :
WO 92/04635 19.03.92 Gazette 92/07

(54) VERFAHREN ZUM ERMITTELN DER KURZSCHLUSSIMPEDANZ EINER ZU ÜBERWACHENDEN ELEKTRISCHEN ENERGIEVERSORGUNGSANLAGE.

(30) Priorität : 11.09.90 DE 4029141

(43) Veröffentlichungstag der Anmeldung :
30.06.93 Patentblatt 93/26

(45) Bekanntmachung des Hinweises auf die
Patenterteilung :
15.06.94 Patentblatt 94/24

(84) Benannte Vertragsstaaten :
CH DE FR GB LI SE

(56) Entgegenhaltungen :
US-A-48 129 95
CIGRE, INTERNATIONAL CONFERENCE ON
LARGE HIGH VOLTAGE ELECTRIC SYSTEMS,
1988 SESSION, 28 august - 3 September 1988,
PROCEEDINGS, Paris, 1988, part 34-11, pages
1-6; V.M. ERMOLENKO et al.: "HIGH SPEED
WAVE DIRECTIONAL RELAY PROTECTION
OF UVH LINES"

(56) Entgegenhaltungen :
CIGRE, INTERNATIONAL CONFERENCE ON
LARGE HIGH VOLTAGE ELECTRIC SYSTEMS,
1988 SESSION, 28 August - 3 September 1988,
PROCEEDINGS, Paris, 1988, part 38 - 10, pages 1-6; E. HOFFMANN et al.: "ON-SITE ME-
ASUREMENT OF THE SHORT CIRCUIT
IMPEDANCE IN HIGH VOLTAGE SYSTEMS"
IMECO TC4 - 3d INTERNATIONAL SYMPO-
SIUM, "MEASUREMENT IN ELECTRICAL AND
ELECTRONIC POWER SYSTEMS", Zürich,
20-22.09.89

(73) Patentinhaber : SIEMENS
AKTIENGESELLSCHAFT
Wittelsbacherplatz 2
D-80333 München (DE)

(72) Erfinder : BÖHME, Klaus
Am Gemeindepark 42
D-1000 Berlin 46 (DE)
Erfinder : FILBERT, Dieter
Heimstättenweg 13
D-1000 Berlin 41 (DE)
Erfinder : RECK, Thomas
Am Forstacker 33
D-1000 Berlin 20 (DE)

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung bezieht sich auf ein Verfahren zum Ermitteln der Kurzschlußimpedanz einer zu überwachenden elektrischen Energieversorgungsanlage, insbesondere einer Energieübertragungsleitung, aus Abtastwerten einer dem Kurzschlußstrom proportionalen Meßgröße und weiteren Abtastwerten einer der Kurzschlußspannung proportionalen weiteren Meßgröße, bei dem

a) Koeffizienten einer Systemmatrix $\underline{X}_i$ und Koeffizienten einer Systemmatrix $\underline{X}_{u1}$ eines vorgewählten Modells einer elektrischen Energieversorgungsanlage unter Berücksichtigung der Netzfrequenz der zu überwachenden Energieversorgungsanlage aus der vorgewählten zeitlichen Abfolge der Abtastwerte der einen Meßgröße bzw. der Abfolge der weiteren Abtastwerte der weiteren Meßgröße berechnet werden, wobei $\underline{X}_i$ bzw. $\underline{X}_{u1}$ durch die Beziehungen

$$\underline{W}_i = \underline{X}_i \cdot \underline{\beta}_i \text{ bzw.} \quad (1)$$
$$\underline{W}_u = \underline{X}_{u1} \cdot \underline{\beta}_{u1} \quad (2)$$

definiert sind, in denen $\underline{W}_i$ bzw. $\underline{W}_u$ jeweils eine durch die Abtastwerte bzw. die weiteren Abtastwerte gegebene Matrix und $\underline{\beta}_i$ bzw. $\underline{\beta}_{u1}$ Parameter-Vektoren darstellen,

b) ausgehend von einem vorgewählten Parameter-Vektor $\underline{\beta}_i(0)$ bzw. $\underline{\beta}_{u1}(0)$ durch rekursive Schätzung unter Berücksichtigung des jeweils nächsten Abtastwertes der einen bzw. weiteren Meßgröße der jeweils nächste Parameter-Vektor ($\underline{\beta}_i(k)$ bzw. $\underline{\beta}_{u1}(k)$ errechnet wird und

c) bei einem vorgegebenen kleinsten Fehler-Vektor die Berechnung des nächsten Parameter-Vektors beendet wird und die Elemente des zuletzt errechneten Parameter-Vektors $\underline{\beta}_i(k+1)$ bzw. $\underline{\beta}_{u1}(k+1)$ zur Bestimmung der Kurzschlußimpedanz herangezogen werden.

Bei einem bekannten Verfahren dieser Art, das auf der Tagung IMEKO im Sept. 1989 in Zürich vorgestellt worden ist (Veröffentlichung "Recursive Estimation in Distance Relaying Systems" von T. Reck und D. Filbert in IMECO TC4 - 3rd International Symposium, "Measurement in Electrical and Electronic Power Systems", Zürich, 20.-22.09.89), wird zum Ermitteln der Kurzschlußimpedanz von einem Modell einer elektrischen Energieversorgungsanlage ausgegangen, dessen Strom i(t) im Kurzschlußfall sich durch die Gleichung (3) beschreiben läßt:

$$i(t) = p_{I1}\sin(\omega t + \pi/4) + p_{I2}\cos(\omega t + \pi/4) + p_{I3} - p_{I4}.t + p_{I5}.t^2 \quad (3)$$

In dieser Gleichung (3) geben die Parameter $p_{I1}$ und $p_{I2}$ die zum Erfassen der Kurzschlußimpedanz benötigten fundamentalen Größen an, während die Parameter $p_{I3}$ bis $p_{I5}$ den Einfluß eines im Kurzschlußstrom enthaltenen, exponentiell abklingenden Gleichstromgliedes nach Entwicklung in eine Taylor-Reihe wiedergeben. Ferner wird zur Durchführung des bekannten Verfahrens berücksichtigt, daß bei einer mathematischen Darstellung des Verhaltens des vorgewählten Modells der elektrischen Energieversorgungsanlage mittels Matrizen sich die folgende Gleichung (4) entwickeln läßt:

$$\begin{vmatrix} y_i(1) \\ \cdot \\ \cdot \\ \cdot \\ y_i(N) \end{vmatrix} = \begin{vmatrix} \sin(\omega t_1 + \pi/4) & \cos(\omega t_1 + \pi/4) & -t_1 & t_1^2 \\ \cdot & \cdot & & \cdot \\ \cdot & \cdot & & \cdot \\ \cdot & \cdot & & \cdot \\ \sin(\omega t_N + \pi/4) & \cos(\omega t_N + \pi/4) & -t_N & t_N^2 \end{vmatrix} \cdot \begin{vmatrix} p_{11} \\ p_{12} \\ p_{13} \\ p_{14} \\ p_{15} \end{vmatrix} \quad (4)$$

Diese Gleichung (4) kann in einer Darstellung mit Vektoren auch geschrieben werden in der Form (5):

$$\underline{W}_i = \underline{X}_i \cdot \underline{\beta}_i \quad (5)$$

Entsprechend ist bei der theoretischen Vorbetrachtung des bekannten Verfahrens hinsichtlich der Darstellung der Spannung im Kurzschlußfalle verfahren, indem von einem Spannungsverlauf an dem Modell einer elektrischen Energieversorgungsanlage gemäß der folgenden Beziehung (6) ausgegangen ist:

$$u(t) = p_{u1}\sin(\omega t + \pi/4) + p_{u2}\cos(\omega t + \pi/4) \quad (6)$$

In Matrizen-Darstellung ergibt sich daraus für die verschiedenen weiteren Abtastwerte $y_u(k)$ eine Beziehung (7) ähnlich der Gleichung (4)

$$
\begin{vmatrix} y_u(1) \\ \cdot \\ \cdot \\ \cdot \\ y_u(N) \end{vmatrix} = \begin{vmatrix} \sin(\omega t_1 + \pi/4) & \cos(\omega t_1 + \pi/4) \\ \cdot & \cdot \\ \cdot & \cdot \\ \cdot & \cdot \\ \sin(\omega t_N + \pi/4) & \cos(\omega t_N + \pi/4) \end{vmatrix} \cdot \begin{vmatrix} p_{u1} \\ p_{u2} \end{vmatrix} \qquad (7)
$$

Diese Beziehung läßt sich ähnlich der nach Gleichung (5) darstellen in der Form:

$$\underline{W}_u = \underline{X}_u \cdot \underline{\beta}_u \quad (8)$$

Ausgehend von diesen grundsätzlichen Überlegungen wird bei der Durchführung des bekannten Verfahrens in der Weise vorgegangen, daß zunächst die Koeffizienten der Systemmatrix $\underline{X}_i$ und der Systemmatrix $\underline{X}_u$ berechnet werden, was anhand der vorgegebenen Abtastzeiten und der ebenfalls vorbekannten Frequenz der zu überwachenden Energieversorgungsanlage ohne weiteres möglich ist. Danach erfolgt die Bestimmung der Parameter-Vektoren $\underline{\beta}_i$ bzw. $\underline{\beta}_u$ durch rekursive Schätzung, wobei zu Beginn dieser Schätzung von einem vorgewählten Parameter-Vektor $\underline{\beta}_i(0) = 0$ bzw. $\underline{\beta}_u(0) = 0$ ausgegangen wird. Unter Berücksichtigung des jeweils nächsten Abtastwertes des Kurzschlußstromes bzw. der Kurzschlußspannung wird der jeweils nächste Parameter-Vektor $\underline{\beta}_i(k+1)$ bzw. $\underline{\beta}_u(k+1)$ errechnet. Bei einem vorgegebenen kleinsten Fehler-Vektor bei der rekursiven Schätzung wird die Berechnung beendet, und es werden die Elemente des zuletzt errechneten Parameter-Vektors $\underline{\beta}_1(k+1)$ bzw. $\underline{\beta}_u(k+1)$ zum Bestimmen der Kurzschlußimpedanz herangezogen. Dabei werden nur die den Sinus- und den Cosinus-Schwingungen zugeordneten Parameter $p_{i1}$ und $p_{i2}$ sowie $p_{u1}$ und $p_{u2}$ berücksichtigt, aus denen sich die Fundamentalanteile in den beiden Meßgrößen (Kurzschlußstrom und Kurzschlußspannung) in bekannter Weise nach Betrag und Phase ermitteln lassen. Daraus wiederum ergibt sich durch Quotientenbildung in einfacher Weise die Kurzschlußimpedanz der zu überwachenden elektrischen Energieversorgungsanlage. In vorteilhafter Weise ist dabei die Bestimmung der Kurzschlußimpedanz unabhängig von Einflüssen des abklingenden Gleichstromgliedes, weil die dieses Gleichstromglied beschreibenden Parameter bei der Errechnung der Kurzschlußimpedanz unberücksichtigt bleiben.

Der Erfindung liegt die Aufgabe zugrunde, ein Verfahren zum Ermitteln der Kurzschlußimpedanz einer zu überwachenden elektrischen Energieversorgungsanlage, insbesondere einer Energieübertragungsleitung, anzugeben, mit dem sich die Kurzschlußimpedanz unabhängig von der Art des Kurzschlusses genau bestimmen läßt.

Zur Lösung dieser Aufgabe wird bei einem Verfahren der eingangs angegebenen Art erfindungsgemäß die Systemmatrix $\underline{X}_{u1}$ unter Erfassung und Berücksichtigung des jeweiligen Vorzeichens der Abtastwerte der einen dem Kurzschlußstrom proportionalen Meßgröße errechnet und bei der Errechnung des Parameter-Vektors $\underline{\beta}_{u1}$ ein einen Lichtbogen bei Kurzschluß berücksichtigendes Zusatz-Element $p_{u3}$ mit herangezogen.

Der wesentliche Vorteil des erfindungsgemäßen Verfahrens besteht darin, daß bei ihm der Einfluß eines Lichtbogens auf die Genauigkeit der Berechnung der Kurzschlußimpedanz ausgeschaltet ist, weil der Einfluß eines mit einem Lichtbogen einhergehenden Kurzschlusses durch ein Zusatz-Element des Parameter-Vektors $\underline{\beta}_{u1}$ gekennzeichnet ist, das beim Ermitteln der Kurzschlußimpedanz nicht berücksichtigt wird.

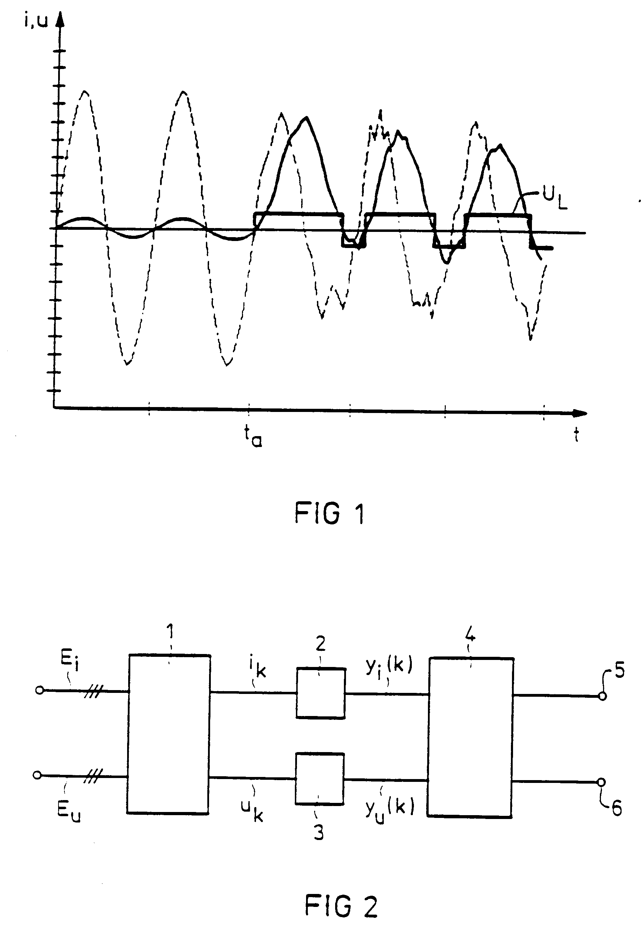

Der Erfindung liegt die Überlegung zugrunde, daß die Impedanz eines Lichtbogens in guter Näherung nur aus einer ohmschen Komponente besteht. Der Kurzschlußstrom verläuft in der Kurzschlußschleife etwa sinusförmig, so daß der nichtlineare Widerstand des Lichtbogens eine etwa rechteckförmige Spannung über dem Lichtbogen verursacht. Demzufolge ergibt sich ein Verlauf der Lichtbogenspannung $U_L$, wie er in Fig. 1 dargestellt ist. In dieser Figur ist übrigens die Spannung in dem zum Zeitpunkt $t_a$ beginnenden Kurzschluß in ihrem Verlauf strichliert dargestellt, während der Kurzschlußstrom ausgezogen wiedergegeben ist. Im Zusammenhang mit der Erfindung wird daher die Spannung u(t) durch folgenden Ansatz (9) beschrieben

$$u_1(t) = p_{u1} \cdot \sin(\omega t) + p_{u2} \cdot \cos(\omega t) + p_{u3} \quad (9)$$

wobei durch das Zusatz-Element $p_{u3}$ der Einfluß eines Lichtbogens beim Kurzschluß gekennzeichnet ist. Der Parameter-Vektor $\underline{\beta}_{u1}$ hat daher folgendes Aussehen:

$$\underline{\beta}_{u1} = \begin{vmatrix} p_{u1} \\ p_{u2} \\ p_{u3} \end{vmatrix} \tag{10}$$

Außerdem ist im Hinblick auf die obigen Ausführungen zum Lichtbogen die Systemmatrix $\underline{X}_{u1}$ durch die Beziehung (11) in Anlehnung an Gleichung (7) definiert:

$$\underline{X}_{u1} = \begin{vmatrix} \sin\omega t_1 & \cos\omega t_1 & s(k) \\ \vdots & \vdots & \vdots \\ \sin\omega t_N & \cos\omega t_N & s(k) \end{vmatrix} \tag{11}$$

mit

$$s(k) = \text{signum}[i(t_k)] \tag{12}$$

wobei $\omega$ die Kreisfrequenz der zu überwachenden Energieversorgungsanlage, $t_1...t_N$ die Abtastzeitpunkte und $s(k)$ das Vorzeichen des jeweiligen Abtastwertes $y_i(k)$ der einen Meßgröße (Kurzschlußstrom) bedeuten.

Das erfindungsgemäße Verfahren erlaubt bei einer Untersuchung des Zusatz-Elementes im Hinblick auf seine Größe auch die Feststellung, ob ein Kurzschluß mit Lichtbogen oder ohne Lichtbogen aufgetreten ist. So kann vorteilhafterweise bei einem oberhalb eines vorgegebenen unteren Wertes liegenden Wert des Zusatz-Elementes ein einen Kurzschluß mit Lichtbogen kennzeichnendes Signal erzeugt werden.

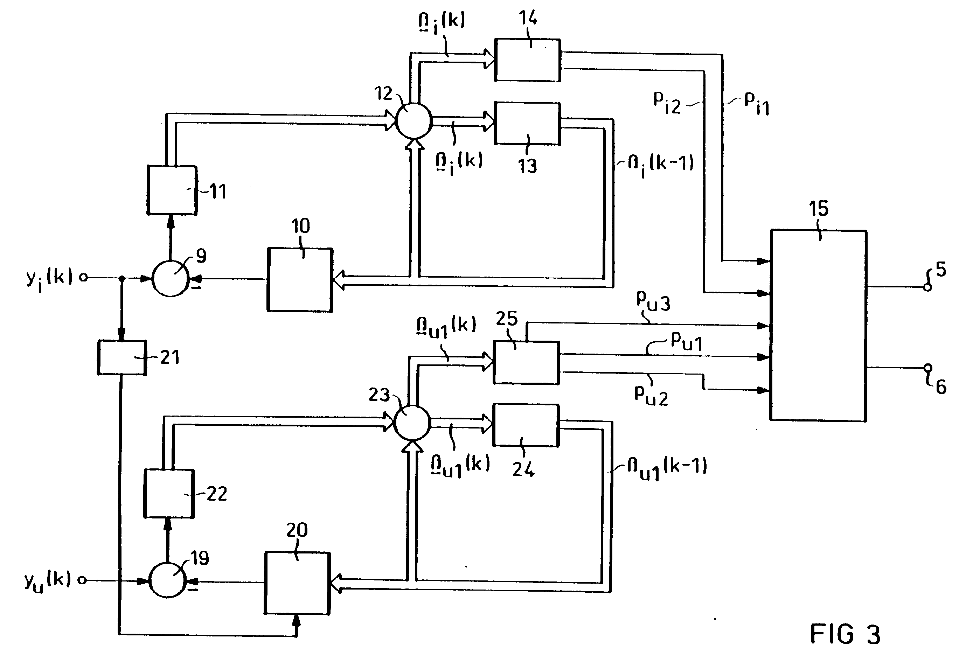

Zur Erläuterung der Erfindung ist in Figur 2 ein sehr stark vereinfachtes Blockschaltbild einer Anordnung zur Durchführung des erfindungsgemäßen Verfahrens und in Figur 3 ein weiteres detailliertes Blockschaltbild wiedergegeben.

Wie die Figur 2 erkennen läßt, ist eine Anordnung zur Durchführung des erfindungsgemäßen Verfahrens mit einem Erfassungsbaustein 1 versehen, der eingangsseitig mit den Strömen i in einer zu überwachenden Energieversorgungsanlage (nicht dargestellt) entsprechenden Eingangsgrößen $E_i$ und mit den Spannungen in der zu überwachenden Energieversorgungsanlage entsprechenden weiteren Eingangsgrößen $E_u$ beaufschlagt ist. In dem Erfassungsbaustein 1 erfolgt durch eine Überprüfung der Eingangsgrößen $E_i$ die Ermittlung des Kurzschlußstromes; eine diesem Kurzschlußstrom entsprechende Meßgröße $i_K$ wird einer Abtasteinrichtung 2 zugeführt. Außerdem wird in dem Erfassungsbaustein 1 die Kurzschlußspannung ermittelt und eine dieser Kurzschlußspannung entsprechende weitere Meßgröße $u_K$ einer weiteren Abtasteinrichtung 3 zugeführt. Von den Abtasteinrichtungen 2 und 3 werden Abtastwerte $y_i(k)$ bzw. $y_u(k)$ einer Einrichtung 4 zur Bestimmung der Kurzschlußimpedanz zugeführt. Diese Einrichtung 4 gibt an einem Ausgang 5 ein Signal ab, dessen Größe der jeweiligen Kurzschlußimpedanz entspricht; an einem weiteren Ausgang 6 kann ein Signal abgegriffen werden, das anzeigt, ob ein Kurzschluß mit oder ohne Lichtbogen vorliegt.

Die rekursive Schätzung der Parameter-Vektoren $\beta_i$ und $\underline{\beta}_{u1}$ kann im Rahmen des erfindungsgemäßen Verfahrens auf unterschiedliche Weise erfolgen, beispielsweise anhand der sog. rekursiven Least-Squares-Schätzung. In diesem Falle erfolgt die Schätzung anhand der folgenden Rekursions-Gleichungen:

$$\underline{\beta}_i(k) = \underline{\beta}_i(k-1) + \underline{K}_i(k).\left|y_i(k) - \underline{X}_i(k).\underline{\beta}_i(k-1)\right| \tag{13}$$

$$\underline{K}_i(k) = \underline{P}_i^*(k)\,\underline{X}_i^T(k).\left|\underline{X}_i(k).\underline{P}_i^*(k).\underline{X}_i^T + 1\right|^{-1} \tag{14}$$

$$\underline{P}_i^*(k) = \underline{P}_i^*(k-1) - \underline{K}_i(k-1).\underline{X}_i(k-1).\underline{P}_i^*(k-1) \tag{15}$$

Die Gleichungen für $\underline{\beta}_{u1}$ sehen entsprechend aus.

Aus den obigen Gleichungen geht hervor, daß der jeweils neue Parameter-Vektor $\underline{\beta}_i(k)$ bzw. $\underline{\beta}_{u1}(k)$ aus jeweils dem alten Parameter-Vektor $\beta_i(k-1)$ bzw. $\underline{\beta}_{u1}(k-1)$ und der mit dem Kalman-Verstärkungsvektor $\underline{K}_i(k)$ bzw. $\underline{K}_{u1}(k)$ multiplizierten Innovation $I_i(k) = y_i(k)-\underline{X}_i(k).\beta_i(k-1)$ bzw. $I_{u1}(k) = y_u(k) -\underline{X}_{u1}(k).\underline{\beta}_u(k-1)$ gebildet wird, wobei der Kalman-Verstärkungsvektor $\underline{K}_i(k)$ mit der Kovarianzmatrix der Parameter $\underline{P}_i^*(k)$ und der bekannten Modellmatrix $\underline{X}_i(k)$ vorab berechnet und gespeichert werden kann.

Zu Beginn der rekursiven Schätzung, d.h. vor Erfassung des ersten Abtastwertes $y_i(1)$ bzw. $Y_u(1)$, ist für die praktische Anwendung als Ausgangspunkt $\underline{\beta}_i(0) = 0$ und $\underline{\beta}_{u1}(0) = 0$ und $\underline{P}_i^* = \alpha . \underline{E}$ und $\underline{P}_{u1}^*(0) = \alpha . \underline{E}$, wobei $\alpha$ zwischen $10^2$ und $10^4$ gewählt ist; $\underline{E}$ bezeichnet die Einheitsmatrix.

In Figur 3 ist die Einrichtung 4 zur Bestimmung der Kurzschlußimpedanz näher dargestellt und so strukturiert gezeigt, wie es dem Ablauf des erfindungsgemäßen Verfahrens entspricht. Diese Einrichtung 4 besteht demzufolge aus zwei im wesentlichen gleichartig aufgebauten Teilen zur Ermittlung einerseits der Parameter-Vektoren $\beta_j$ anhand der abgetasteten Werte $y_i(k)$ und andererseits zur Ermittlung der Parameter-Vektoren $\beta_{u1}$ aus den abgetasteten Werten $y_u(k)$. Die Abtastwerte $y_i(k)$ werden nacheinander entsprechend der Gleichung (13) einem Summierglied 9 zugeführt, dem mit negativen Vorzeichen auch die Ausgangsgröße eines Bausteins 10 zugeführt ist. In diesem Baustein 10 ist die vorausberechnete Systemmatrix $\underline{X}_j$ abgelegt; außerdem erfolgt hier eine Multiplikation eines Parameter-Vektors $\underline{\beta}_j(k-1)$, der auf einen vorangehenden Abtastwert $y_i(k-1)$ hin ermittelt worden ist, mit der Systemmatrix $\underline{X}_j(k)$ für den aktuellen Abtastwert $y_i(k)$. Die sich aus der Summations- bzw. Differenzbildung von $y_i(k)$ und der Ausgangsgröße des Bausteines 10 ergebende Größe - entspricht dem Ausdruck $y_i(k)-\underline{X}_j.(k).\underline{\beta}_j(k-1)$ der Gleichung (13) - wird in einem weiteren Baustein 11 mit einem sogenannten Kalman-Verstärkungsvektor $\underline{K}_j(k)$ multipliziert. Die Ausgangsgröße des weiteren Bausteins 11 gelangt an ein weiteres Summierglied 12, in dem eine Addition der Ausgangsgröße des Bausteines 11 und des Parameter-Vektors $\underline{\beta}_j(k-1)$ erfolgt. Von diesem weiteren Summierglied 12 wird der durch die Addition gebildete Parameter-Vektor $\underline{\beta}_j(k)$ einem Speicherglied 13 zugeführt und dort anstelle des bisher dort abgelegten Parameter-Vektors $\underline{\beta}_1(k-1)$ gespeichert. Außerdem wird der Parameter-Vektor $\underline{\beta}_j(k)$ einem Selektionsglied 14 zugeführt, das den Parametern $p_{i1}$ bzw. $p_{i2}$ des Vektors $\underline{\beta}_j.(k)$ entsprechende Meßgrößen abgibt, die einem Berechnungsglied 15 zugeführt werden.

Ähnlich ist der in der Figur 3 untere Teil des Bausteins 4 ausgeführt, in dem die Abtastwerte $y_u(k)$ der weiteren Meßgröße (Kurzschlußspannung) verarbeitet werden. Diese Abtastwerte werden einem Summierbaustein 19 zugeführt, dem mit negativem Vorzeichen das Produkt $\underline{X}_{u1}(k) . \underline{\beta}_u(k-1)$ zugeführt wird. Dieses Produkt wird in einem weiteren Baustein 20 gebildet, in dem einerseits die Systemmatrix $\underline{X}_{u1}$ und in dem andererseits eine Multiplikation mit dem Parameter-Vektor $\underline{\beta}_{u1}(k-1)$ für den vorangehenden Abtastwert gebildet werden. Die Systemmatrix $\underline{X}_{u1}$ wird während der rekursiven Schätzung ständig hinsichtlich ihrer letzten Spalte $s(k)$ ergänzt, indem ein mit den Abtastwerten $Y_i(k)$ beaufschlagter Vorzeichengeber 21 ein entsprechendes Signal in den weiteren Baustein 20 einschreibt. Die Summe bzw. die Differenz aus dem Abtastwert $y_u(k)$ und der Ausgangsgröße des weiteren Bausteins 20 wird einem zusätzlichen Baustein 22 zugeführt, in dem der Kalman-Verstärkungsvektor $\underline{K}_{u1}(k)$ gebildet wird. Es erfolgt in diesem zusätzlichen Baustein 22 eine Multiplikation der Ausgangsgröße des Bausteins 20 mit dem Kalman-Verstärkungsfaktor, so daß am Ausgang dieses zusätzlichen Bausteins 22 ein Signal auftritt, das der Beziehung genügt:

$$K_{u1}(k) . \left| y_u(k) - \underline{X}_{u1}(k).\underline{\beta}_{u1}(k - 1) \right|$$

In einem weiteren Summationsbaustein 23 wird zu dieser Größe der Parameter-Vektor $\beta_{u1}(k-1)$ addiert, wodurch im Rahmen rekursiver Schätzung ein neuer Parameter-Vektor $\underline{\beta}_{u1}(k)$ entsteht. Dieser Vektor $\underline{\beta}_{u1}(k)$ wird einerseits einem weiteren Speicher 24 zugeführt und ersetzt dort den bisher abgelegten Parameter-Vektor $\beta_{u1}(k-1)$ und andererseits einem weiteren Selektionsglied 25 zugeführt, das an zwei Ausgängen die für die Bestimmung der Kurzschlußimpedanz wichtigen Parameter $p_{u1}$ und $p_{u2}$ abgibt. An einem weiteren Ausgang des weiteren Selektionsgliedes 25 ist ein dem Zusatz-Element $p_{u3}$ entsprechendes Signal abgreifbar, das mittels einer in dem Berechnungsglied 15 vorgesehenen Schwellwertschaltung daraufhin untersucht werden kann, ob ein Kurzschluß mit Lichtbogen aufgetreten ist oder nicht. Liegt ein Kurzschluß mit Lichtbogen vor, dann kann ggf. eine Kurzunterbrechung vorgenommen werden, um vor einer Abschaltung der zu überwachenden Energieversorgungsanlage einen Versuch zur Behebung des Kurzschlusses unternehmen zu können. Liegt ein Kurzschluß ohne Lichtbogen vor, dann kann auf eine Kurzunterbrechung verzichtet werden.

Die den Parametern $p_{u1}$ und $p_{u2}$ entsprechenden Meßgrößen werden ebenfalls dem Berechnungsglied 15 zugeführt, das dann eine Berechnung durchführt, wenn im Rahmen der rekursiven Schätzung sich bei der Berechnung der Parameter-Vektoren $\underline{\beta}_j$ und $\underline{\beta}_{u1}$ ein vorgegebener minimaler Fehler-Vektor ergeben hat. Es ist aber auch möglich, die rekursive Schätzung nach einer vorgegebenen Zeitdauer abzubrechen.

Abschließend ist darauf hinzuweisen, daß die Durchführung des erfindungsgemäßen Verfahrens in der Praxis mittels einer elektronischen Datenverarbeitungsanlage erfolgt; die dargestellten Blockschaltbilder dienen nur zur Veranschaulichung des erfindungsgemäßen Verfahrens.


**Patentansprüche**

1.  Verfahren zum Ermitteln der Kurzschlußimpedanz einer zu überwachenden elektrischen Energieversorgungsanlage, insbesondere einer Energieübertragungsleitung, aus Abtastwerten einer dem Kurzschlußstrom proportionalen Meßgröße und weiteren Abtastwerten einer der Kurzschlußspannung proportionalen weiteren Meßgröße, bei dem
    a) Koeffizienten einer Systemmatrix $\underline{X}_j$ und Koeffizienten einer Systemmatrix $\underline{X}_{u1}$ eines vorgewählten

Modells einer elektrischen Energieversorgungsanlage unter Berücksichtigung der Netzfrequenz der zu überwachenden Energieversorgungsanlage aus der vorgewählten zeitlichen Abfolge der Abtastwerte der einen Meßgröße bzw. der Abfolge der weiteren Abtastwerte der weiteren Meßgröße berechnet werden, wobei $\underline{X}_i$ bzw. $\underline{X}_{u1}$ durch die Beziehung

$$\underline{W}_i = \underline{X}_i \cdot \underline{\beta}_i \text{ bzw.}$$
$$\underline{W}_u = \underline{X}_{u1} \cdot \underline{\beta}_{u1}$$

definiert sind, in der $\underline{W}_i$ bzw. $\underline{W}_u$ jeweils eine durch die Abtastwerte bzw. die weiteren Abtastwerte gegebene Matrix und $\underline{\beta}_i$ bzw. $\underline{\beta}_{u1}$ Parameter-Vektoren darstellen,

b) ausgehend von einem vorgewählten Parameter-Vektor $\underline{\beta}_i(0)$ bzw. $\underline{\beta}_{u1}(0)$ durch rekursive Schätzung unter Berücksichtigung des jeweils nächsten Abtastwertes der einen bzw. weiteren Meßgröße der jeweils nächste Parameter-Vektor $\underline{\beta}_i(k)$ bzw. $\underline{\beta}_{u1}(k)$ errechnet wird und

c) bei einem vorgegebenen kleinsten Fehler-Vektor die Berechnung des nächsten Parameter-Vektors beendet wird und die Elemente des zuletzt errechneten Parameter-Vektors $\underline{\beta}_i(k+1)$ bzw. $\underline{B}_{u1}(k+1)$ zur Bestimmung der Kurzschlußimpedanz herangezogen werden,

**dadurch gekennzeichnet, daß**

i) die Systemmatrix $\underline{X}_{u1}$ unter Erfassung und Berücksichtigung des jeweiligen Vorzeichens der Abtastwerte der einen dem Kurzschlußstrom proportionalen Meßgröße errechnet wird und

j) bei der Errechnung des Parameter-Vektors $\underline{\beta}_{u1}$ ein einen Lichtbogen bei Kurzschluß berücksichtigendes Zusatz-Element $p_{u3}$ mit her angezogen wird.

2. Verfahren nach Anspruch 1, **dadurch gekennzeichnet**, daß
k) die Systemmatrix $\underline{X}_{u1}$ nach der Formel

$$\underline{X}_{u1} = \begin{vmatrix} \sin\omega t_1 & \cos\omega t_1 & s(k) \\ \vdots & \vdots & \vdots \\ \sin\omega t_N & \cos\omega t_N & s(k) \end{vmatrix}$$

mit

$$s(k) = \text{signum } [i(t_k)]$$

berechnet wird, wobei die Kreisfrequenz der zu überwachenden Energieversorgungsanlage, $t_1 \dots t_N$ die Abtastzeitpunkte und s(k) das Vorzeichen des jeweiligen Abtastwertes $i(t_k)$ der einen Meßgröße bedeuten.

3. Verfahren nach Anspruch 1 oder 2, **dadurch gekennzeichnet, daß**
l) bei einem oberhalb eines vorgegebenen unteren Wertes liegenden Wert des Zusatz-Elementes $P_{u3}$ ein einen Kurzschluß mit Lichtbogen kennzeichnendes Signal erzeugt wird.

**Claims**

1. Method for determining the short-circuit impedance of an electric power supply system to be monitored, in particular a power transmission line, from scanning values of a measured variable proportional to the short-circuit current and further scanning values of a further measured variable proportional to the short-circuit voltage, where

a) coefficients of a system matrix $\underline{X}_i$ and coefficients of a system matrix $\underline{X}_{u1}$ of a preselected model of an electric power supply system with consideration of the line frequency of the power supply system to be monitored are calculated from the preselected temporal sequence of the scanning values of the one measured variable or the sequence of the further scanning values of the further measured variable, with $\underline{X}_i$ and $\underline{X}_{u1}$ being defined by the equation

$$\underline{W}_i = \underline{X}_i \cdot \underline{\beta}_i \qquad \text{and}$$
$$\underline{W}_u = \underline{X}_{u1} \cdot \underline{\beta}_{u1}$$

in which $\underline{W}_i$ and $\underline{W}_u$ in each case represent a matrix given by the scanning values and the further scanning values and $\underline{\beta}_i$ and $\underline{\beta}_{u1}$ represent parameter vectors,

b) proceeding from a preselected parameter vector $\underline{\beta}_i(0)$ and $\underline{\beta}_{u1}(0)$, through recursive estimation with consideration of the respectively next scanning value of the one or further measured variable, the respectively next parameter vector $\underline{\beta}_i(k)$ or $\underline{\beta}_{u1}(k)$ is calculated and

c) with a specified smallest error vector the calculation of the next parameter vector is ended and the elements of the last calculated parameter vector $\underline{\beta}_i$ (k+1) or $\underline{\beta}_{u1}$(k+1) are used to determine the short-circuit impedance,

characterized in that

i) the system matrix $\underline{X}_{u1}$ with detection and consideration of the respective sign of the scanning values of the one measured variable proportional to the short-circuit current is calculated, and

j) upon the calculation of the parameter vector $\underline{\beta}_{u1}$ an additional element $p_{u3}$ considering an arc upon short circuit is also used.

2. Method according to claim 1,
characterized in that
k) the system matrix $\underline{X}_{u1}$ is calculated according to the formula

$$\underline{X}_{u1} = \begin{vmatrix} \sin\omega t_1 & \cos\omega t_1 & s(k) \\ \cdot & \cdot & \cdot \\ \cdot & \cdot & \cdot \\ \cdot & \cdot & \cdot \\ \sin\omega t_N & \cos\omega t_N & s(k) \end{vmatrix}$$

with

$$s(k) = \text{signum } [i(t_k)]$$

with $\omega$ signifying the circuit frequency of the power supply system to be monitored, $t_i \ldots t_N$ signifying the scanning instants and s(k) signifying the sign of the respective scanning value $i(t_k)$ of the one measured variable.

3. Method according to claim 1 or 2,
characterized in that
l) with a value of the additional element $p_{u3}$ lying above a specified lower value a signal characterizing a short circuit with arc is generated.


**Revendications**

1. Procédé pour déterminer l'impédance en court-circuit d'une installation d'alimentation en énergie électrique à contrôler, notamment d'une ligne de transport d'énergie, à partir de valeurs d'échantillonnage d'une grandeur de mesure proportionnelle au courant de court-circuit et d'autres valeurs d'échantillonnage d'une autre grandeur de mesure proportionnelle à la tension de court-circuit, selon lequel

a) on calcule des coefficients d'une matrice $\underline{X}_i$ du système et des coefficients d'une matrice $\underline{X}_{u1}$ du système d'un modèle présélectionné d'une installation d'alimentation en énergie électrique, en tenant compte de la fréquence du réseau de l'installation d'alimentation en énergie à contrôler, à partir de la séquence temporelle présélectionnée de valeurs d'échantillonnage d'une grandeur de mesure et de la séquence des autres valeurs d'échantillonnage des autres grandeurs de mesure, $\underline{X}_i$ et $\underline{X}_{u1}$ étant définis par la relation

$$\underline{W}_i = \underline{X}_i \cdot \underline{\beta}_i \text{ et}$$
$$\underline{W}_u = \underline{X}_{u1} \cdot \underline{\beta}_{u1}$$

dans laquelle $\underline{W}_i$ et $\underline{W}_u$ représentent respectivement une matrice qui est définie par les valeurs d'échantillonnage ou les autres valeurs d'échantillonnage, et $\underline{\beta}_i$ et $\underline{\beta}_{u1}$ représentant des vecteurs de paramètres,

b) à partir d'un vecteur de paramètre présélectionné $\underline{\beta}_i(0)$ ou $\underline{\beta}_{u1}(0)$, on calcule par estimation récursive et en tenant compte de la valeur d'échantillonnage respective immédiatement suivante de l'une ou l'autre des grandeurs de mesure, le vecteur de paramètre respectif immédiatement suivant $\underline{\beta}_i(k)$ ou $\underline{\beta}_{u1}(k)$, et

c) pour le vecteur d'erreur prédéterminé le plus petit, on arrête le calcul du vecteur de paramètre immédiatement suivant et on utilise les éléments du vecteur de paramètre $\underline{\beta}_i(k+1)$ ou $\underline{\beta}_{u1}(k+1)$, calculé en dernier lieu, pour déterminer l'impédance en court-circuit,

caractérisé par le fait que

i) on calcule la matrice $\underline{X}_{u1}$ du système en déterminant et en tenant compte du signe respectif des valeurs d'échantillonnage dans une grandeur de mesure proportionnelle au courant de court-circuit, et

j) en dehors du calcul du vecteur de paramètre $\underline{\beta}_{u1}$, on utilise un élément supplémentaire $P_{u3}$, qui tient compte d'un arc électrique lors du court-circuit.

2.   Procédé suivant la revendication 1, caractérisé par le fait que

k) on calcule la matrice $\underline{X}_{u1}$ du système selon la formule

$$\underline{X}_{u1} = \begin{vmatrix} \sin\omega t_1 & \cos\omega t_1 & s(k) \\ \cdot & \cdot & \cdot \\ \cdot & \cdot & \cdot \\ \cdot & \cdot & \cdot \\ \sin\omega t_N & \cos\omega t_N & s(k) \end{vmatrix}$$

avec

$$s(k) = \text{signe de } [i(t_k)]$$

$\omega$ désignant la fréquence angulaire de l'installation d'alimentation en énergie à contrôler, $t_1...t_N$ les instants d'échantillonnage et $s(k)$ le signe de la valeur respective d'échantillonnage $i(t_k)$ d'une grandeur de mesure.

3.   Procédé suivant la revendication 1 ou 2, caractérisé par le fait que

l) dans le cas où une valeur de l'élément supplémentaire $P_{u3}$ est supérieure à une valeur inférieure prédéterminée, un signal caractérisant un court-circuit avec un arc électrique est produit.

FIG 1

FIG 2

FIG 3

$\underline{\vartheta}_i(k)$ — 14

12 — $\underline{\vartheta}_i(k)$ — 13

$P_{i2}$ — $P_{i1}$

11 — 9 — $y_i(k)$ — 10 — 15 — 5

$\vartheta_i(k-1)$

21

$\underline{\vartheta}_{u1}(k)$ — 25

$P_{u3}$ — $P_{u1}$ — $P_{u2}$ — 6

23 — $\underline{\vartheta}_{u1}(k)$ — 24

$\vartheta_{u1}(k-1)$

22 — 20 — 19 — $y_u(k)$

EP 0 548 129 B1